# EUROPEAN PATENT SPECIFICATION

(11) **EP 3 836 200 B1**
(45) Date of publication and mention of the grant of the patent: **23.07.2025**
(21) Application number: 19847209.4
(22) Date of filing: 26.07.2019
(51) Int. Cl.: G06F 1/10, H01L 23/528, H10D 84/01, H10D 84/03

(54) **SEMICONDUCTOR INTEGRATED CIRCUIT AND ELECTRONIC INSTRUMENT**
INTEGRIERTE HALBLEITERSCHALTUNG UND ELEKTRONISCHES INSTRUMENT
CIRCUIT INTÉGRÉ SEMI-CONDUCTEUR ET INSTRUMENT ÉLECTRONIQUE

(30) Priority: 09.08.2018 JP 2018150466
(43) Date of publication of application: 16.06.2021
(73) Proprietor: Sony Semiconductor Solutions Corporation, Atsugi-shi, Kanagawa 243-0014 (JP)
(72) Inventor: SHIODA Maki, Atsugi-shi, Kanagawa 243-0021 (JP); HASEGAWA Takashi, Atsugi-shi, Kanagawa 243-0021 (JP)
(74) Representative: MFG Patentanwälte Meyer-Wildhagen Meggle-Freund Gerhard PartG mbB
(86) International application number: PCT/JP2019/029367
(87) International publication number: WO 2020/031743

(56) References cited:
- WO-A1-2017/122417
- JP-A- H0 621 221
- JP-A- H02 224 370
- JP-A- H05 121 548
- US-A1- 2008 256 380
- US-A1- 2017 186 691
- US-B1- 7 759 801

## Description

### TECHNICAL FIELD

The present disclosure relates to a semiconductor integrated circuit and an electronic apparatus, and more particularly, to a semiconductor integrated circuit and an electronic apparatus capable of having further improved performance.

### BACKGROUND ART

Generally, in a semiconductor integrated circuit, wirings configuring a wiring network (hereinafter referred to as the same net) through which the same signal is transmitted have a wiring shape designed to have the same wiring width. Furthermore, conventionally, wirings that have been attempted to be variously optimized have been proposed.

For example, Patent Document 1 proposes a wiring layout that minimizes a wiring delay by performing optimization in consideration of a wiring interval. Furthermore, Patent Document 2 proposes a clock wiring method for reducing clock skew by adjusting a length of adjacent wirings and non-uniformity of a wiring capacity due to intersection of interlayer wirings.

US 2017/186691 A1 discloses a clock tree structure disposed on a semiconductor substrate. The clock tree structure includes a first clock line that has a first line width and is arranged at a first height as measured from an upper surface of the semiconductor substrate. The clock tree structure also includes a second clock line that has a second line width, which differs from the first line width. The second clock line is arranged at a second height as measured from the upper surface of the semiconductor substrate and the second height is equal to the first height. The first line width is directly proportional to a first current level for the first clock line and the second line width is directly proportional to a second current level for the second clock line.

US 7,759,801 B1 discloses a first wire that has sidewalls of an integrated circuit and that is tapered from a proximal end to a distal end to reduce width from a first width to a second width. A second wire is spaced apart from the first wire and has sidewalls. The first wire and the second wire are each horizontally disposed alongside each other and form a part of a sidewall capacitor between facing sidewalls. The sidewall capacitor capacitance is progressively reduced responsive to the first wire taper.

US 2008/256380 A1 discloses a functional block that is divided into a plurality of regions. In each region, a clock main line that extends along a first direction, a clock branch line group that includes a plurality of clock branch lines that extend along a second direction perpendicular to the first direction and that are electrically connected to the clock main line, a clock driving cell that is electrically connected to the clock main line and a clock synchronous cell group that includes a plurality of clock synchronous cells that are electrically connected to the clock main line or the clock branch line group are provided. The clock branch line groups of the respective regions are electrically separated from each other, and the clock driving cell singly drives the clock main line that is connected thereto and the clock branch line group that is connected to the clock main line.

### CITATION LIST

### PATENT DOCUMENT

Patent Document 1: Japanese Patent Application Laid-Open No. 2002-313921
Patent Document 2: Japanese Patent Application Laid-Open No. 2001-228931

### SUMMARY OF THE INVENTION

### PROBLEMS TO BE SOLVED BY THE INVENTION

By the way, even in the same net, a variation in a current density occurs on one wiring, such that performance might be deteriorated in the wiring shape having the same wiring width. For example, in a case where the same wiring width is designed to be large, the performance is deteriorated in terms of power consumption, speed or the like due to an unnecessary wiring capacity.

Note that since the wiring layout proposed in Patent Document 1 described above is not a technology related to the same net and the clock wiring method proposed in Patent Document 2 is not a technology related to a wiring shape, such a problem could not be solved.

Therefore, it has been required to avoid the deterioration of the performance occurring in the conventional wiring shape, optimize the wiring shape in the same net, and improve performance of the semiconductor integrated circuit.

The present disclosure has been made in view of such a situation, and an object of the present disclosure is to be capable of further improving performance.

### SOLUTIONS TO PROBLEMS

According to a first aspect, the present invention provides a semiconductor integrated circuit in accordance with independent claim 1. According to a second aspect, the present invention provides an electronic apparatus in accordance with claim 8. Further aspects are set forth in the dependent claims, the drawings and the following description.

A semiconductor integrated circuit according to one aspect of the present disclosure includes: a wiring that forms a transmission network through which the same signal is transmitted; and a driver that supplies the signal to the wiring, in which the wiring has a wiring shape set according to a distance from the driver or a frequency of the signal.

An electronic apparatus according to one aspect of the present disclosure includes: a semiconductor integrated circuit that includes: a wiring that forms a transmission network through which the same signal is transmitted; and a driver that supplies the signal to the wiring, in which the wiring has a wiring shape set according to a distance from the driver or a frequency of the signal.

In one aspect of the present disclosure, a wiring that forms a transmission network through which the same signal is transmitted has a wiring shape set according to a distance from a driver that supplies the signal to the wiring or a frequency of the signal.

### EFFECTS OF THE INVENTION

According to one aspect of the present disclosure, it is possible to further improve the performance.

Note that an effect described here is not necessarily limited, and may be any effect described in the present disclosure.

### BRIEF DESCRIPTION OF DRAWINGS

Fig. 1 is a diagram illustrating a circuit diagram of a clock wiring to which the present technology is applied.
Fig. 2 is a layout diagram illustrating a conventional wiring shape.
Fig. 3 is a layout diagram illustrating a wiring shape according to a first embodiment.
Fig. 4 is an enlarged view of a part of Fig. 3.
Fig. 5 is a layout diagram illustrating another wiring shape according to the first embodiment.
Fig. 6 is an enlarged view of a part of Fig. 5.
Fig. 7 is a diagram illustrating a specific configuration example of the wiring shape of Fig. 3.
Fig. 8 is a diagram illustrating a modification of the wiring shape illustrated in Fig. 7.
Fig. 9 is a diagram for describing a wiring shape in which the first embodiment is applied to a long-distance wiring.
Fig. 10 is a diagram illustrating a specific configuration example of the wiring shape of Fig. 9.
Fig. 11 is a layout diagram illustrating a wiring shape according to a second embodiment.
Fig. 12 is an enlarged view of a part of Fig. 11.
Fig. 13 is a layout diagram illustrating another wiring shape according to the second embodiment.
Fig. 14 is an enlarged view of a part of Fig. 13.
Fig. 15 is a diagram illustrating a specific configuration example of the wiring shape of Fig. 13.
Fig. 16 is a diagram for describing a wiring shape in which the second embodiment is applied to a long-distance wiring.
Fig. 17 is a diagram illustrating a specific configuration example of the wiring shape of Fig. 16.
Fig. 18 is a layout diagram of a power supply wiring.
Fig. 19 is a diagram for describing impedance matching.
Fig. 20 is a diagram for describing occurrence of current concentration.
Fig. 21 is a block diagram illustrating a configuration example of an electronic apparatus including a semiconductor integrated circuit.

### MODE FOR CARRYING OUT THE INVENTION

Hereinafter, specific embodiments to which the present technology is applied will be described in detail with reference to the drawings.

### <First embodiment of wiring shape>

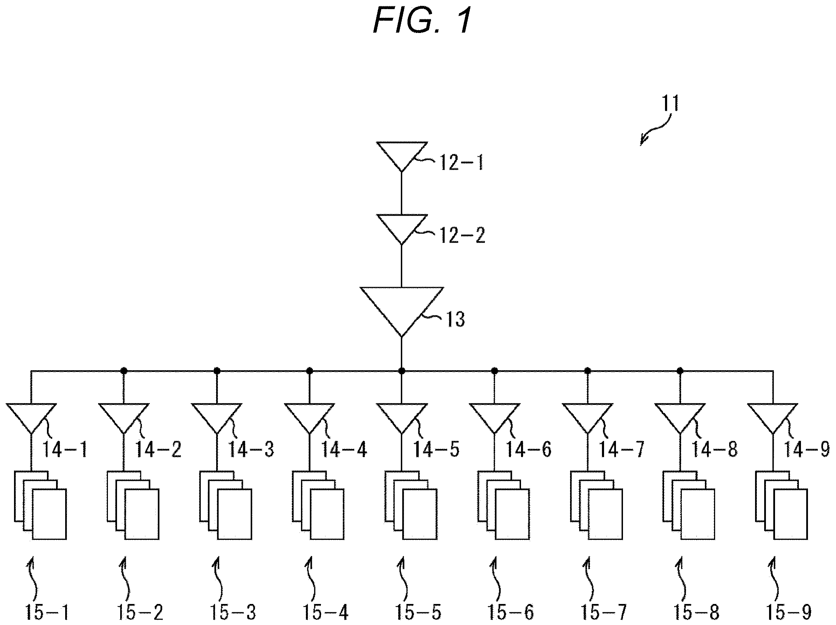

A first embodiment of a wiring shape used in a semiconductor integrated circuit to which the present technology is applied will be described with reference to Figs. 1 to 10.

Fig. 1 illustrates a circuit diagram of a clock wiring to which the present technology is applied.

In a clock wiring 11 illustrated in Fig. 1, signal lines of the same net are designed so that clock signals output from a clock generation circuit (not illustrated) are supplied to a driver 13 via buffers 12-1 and 12-2 and are supplied from the driver 13 to a plurality of receivers 14. In an example illustrated in Fig. 1, a wiring shape of the clock wiring 11 is designed so that the signal lines are branched from an output terminal of the driver 13 and are connected to input terminals of nine receivers 14-1 to 14-9. Then, drive elements 15-1 to 15-9 that drive according to the clock signal are connected to the receivers 14-1 to 14-9, respectively.

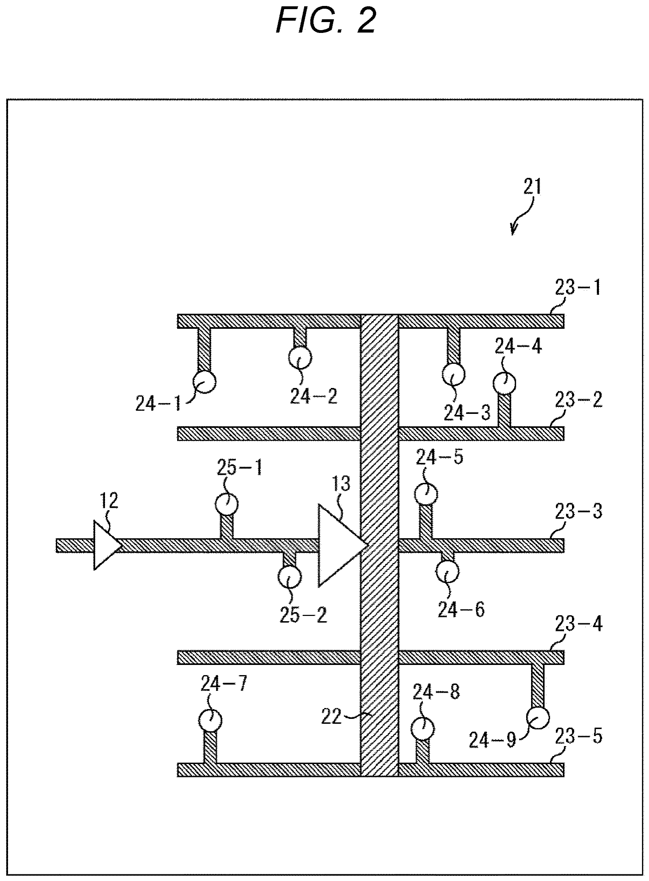

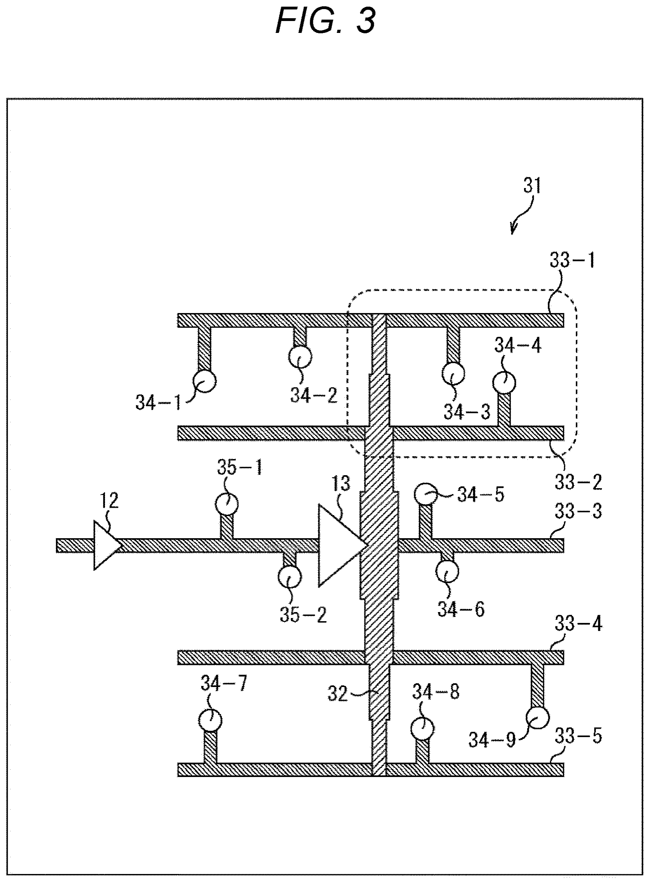

In such a clock wiring 11, a special wiring shape is often used, and for example, a so-called fishbone wiring shape as illustrated in Figs. 2 and 3 is used.

Fig. 2 is a layout diagram illustrating a conventional wiring shape based on the circuit diagram illustrated in Fig. 1.

A clock wiring 21 illustrated in Fig. 2 has a fishbone wiring shape in which a trunk line 22, which is a signal line having a large wiring width, is connected to an output terminal of a driver 13 and branch lines 23, which are a plurality of signal lines having a small wiring width, are connected to the trunk line 22 so as to be branched from the trunk line 22. In an example illustrated in Fig. 2, five branch lines 23-1 to 23-5 are connected to the trunk line 22.

Furthermore, in the clock wiring 21, connection terminals 24-1 to 24-9 connected to the receivers 14-1 to 14-9 of Fig. 1 are provided on the branch lines 23-1 to 23-5. Furthermore, connection terminals 25-1 and 25-2 are also provided between a buffer 12 and the driver 13.

Then, conventionally, in such a clock wiring 21, the trunk line 22 and the branch line 23 are designed so that wiring widths are constant.

Fig. 3 illustrates a layout diagram illustrating a wiring shape to which the present technology is applied, based on the circuit diagram illustrated in Fig. 1.

A clock wiring 31 illustrated in Fig. 3 has a fishbone wiring shape in which five branch lines 33-1 and 33-5 having a small wiring width are connected to a trunk line 32 having a large wiring width so as to be branched from the trunk line 32, similar to the clock wiring 21 of Fig. 2. Note that the clock wiring 31 of Fig. 3 has a layout in which the trunk line 32 is arranged along a vertical direction of a semiconductor integrated circuit.

Furthermore, in the clock wiring 31, connection terminals 34-1 to 34-9 connected to the receivers 14-1 to 14-9 of Fig. 1 are provided on the branch lines 33-1 to 33-5. Furthermore, connection terminals 35-1 and 35-2 are also provided between a buffer 12 and the driver 13.

Then, in the clock wiring 31, an output terminal of the driver 13 is connected to the center of the trunk line 32, and the trunk line 32 has a wiring shape set so that a wiring width becomes smaller according to a distance from a connection portion of the driver 13 to upper and lower sides of the trunk line 32 in the vertical direction. That is, since a current density of a signal transmitted via the trunk line 32 decreases as a distance from the driver 13 increases, the wiring shape of the trunk line 32 is set so that the wiring width corresponds to the decrease in the current density.

Note that since the decrease in the current density changes not only according to the number of receivers, or the like, as well as the distance from the driver 13, it is preferable to form the trunk line 32 of which wiring width becomes smaller so as to be optimized according to the current density of the signal transmitted via the trunk line 32.

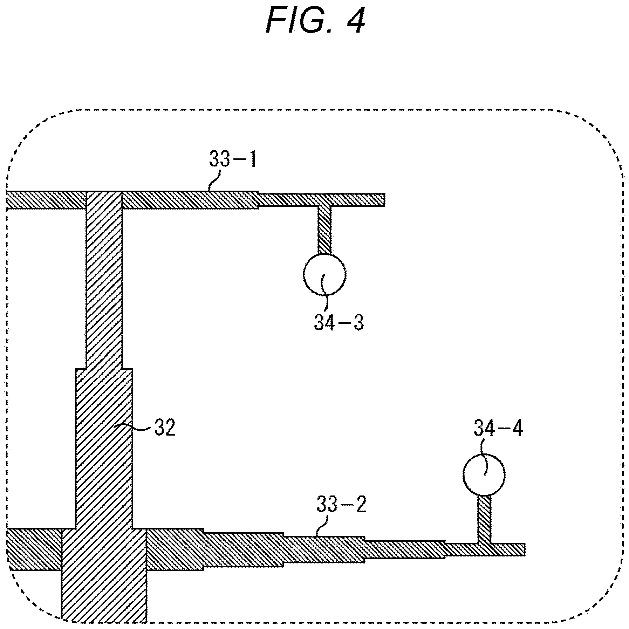

Fig. 4 enlarges and illustrates an area surrounded by a broken line in Fig. 3.

The branch lines 33-1 and 33-2 illustrated in Fig. 4 have wiring shapes set so that wiring widths become smaller according to distances from branch portions with the trunk line 32 to the right in a horizontal direction, that is, as distances from the driver 13 increase, similar to the trunk line 32. Of course, although not illustrated, the branch lines 33-1 and 33-2 extending from the trunk line 32 to the left also have wiring shapes set so that wiring widths become smaller according to distances from branch portions, and the same applies to the branch lines 33-3 to 33-5.

As such, in the clock wiring 31, the trunk line 32 and the branch line 33 have the wiring shapes designed so that the wiring widths become smaller as the distances from the driver 13 increase. Then, in the clock wiring 31, a wiring property can be improved by optimizing the wiring widths of the trunk line 32 and the branch line 33. Therefore, the clock wiring 31 can reduce, for example, an unnecessary wiring capacity, and can avoid deterioration in performance in terms of power consumption, speed, or the like. Furthermore, in a case where the receiver 14 that receives a signal is a complementary metal oxide semiconductor (CMOS), it is preferable to narrow the wiring widths of the trunk line 32 and the branch line 33 so as to suppress reflection at end portions of the trunk line 32 and the branch line 33.

As a result, performance of the semiconductor integrated circuit including the clock wiring 31 can be improved. For example, in accordance with a reduction in a wiring capacity in the clock wiring 31, a size of the driver 13 can be reduced, such that further power reduction becomes possible. In particular, in a case where the clock wiring 31 adopts the fishbone wiring shape, such an effect can be obtained well.

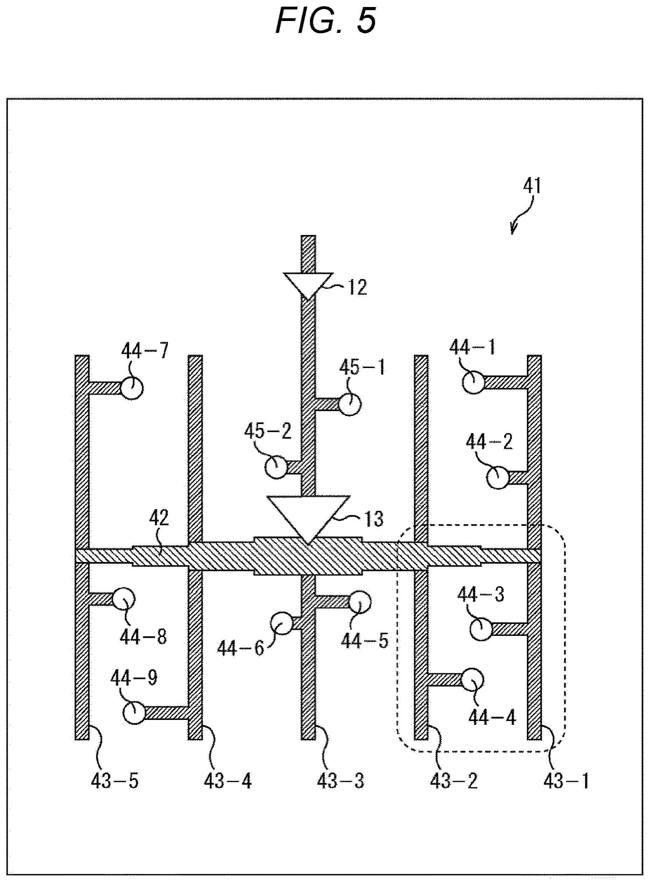

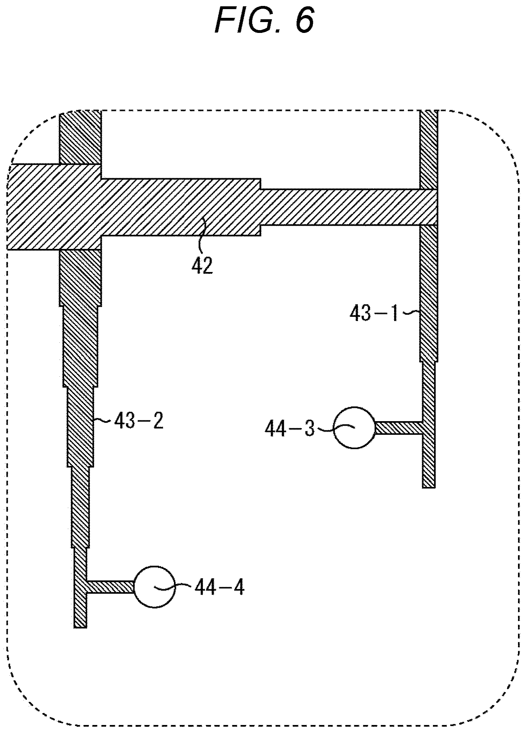

Fig. 5 illustrates a layout diagram illustrating a wiring shape to which the present technology is applied, based on the circuit diagram illustrated in Fig. 1, similar to Fig. 3. Furthermore, Fig. 6 enlarges and illustrates an area surrounded by a broken line in Fig. 5, similar to Fig. 4.

A clock wiring 41 illustrated in Figs. 5 and 6 has a layout in which a trunk line 42 to which the driver 13 is connected is arranged along the horizontal direction of the semiconductor integrated circuit.

Then, as illustrated in Fig. 5, in the clock wiring 41, similar to the clock wiring 31 of Fig. 3, the trunk line 42 to which the driver 13 is connected has a wiring shape set so that a wiring width becomes smaller according to a distance from a connection portion of the driver 13 to the left and right in the horizontal direction. Furthermore, as illustrated in Fig. 6, a branch line 43 branching from the trunk line 42 has a wiring shape set so that a wiring width becomes smaller according to a distance from a branch portion with the trunk line 42 to a lower side in the vertical direction, that is, as a distance from the driver 13 increases.

In the clock wiring 41 having such a wiring shape, similar to the clock wiring 31 of Fig. 3, better performance can be obtained by optimizing the wiring widths of the trunk line 42 and the branch line 43.

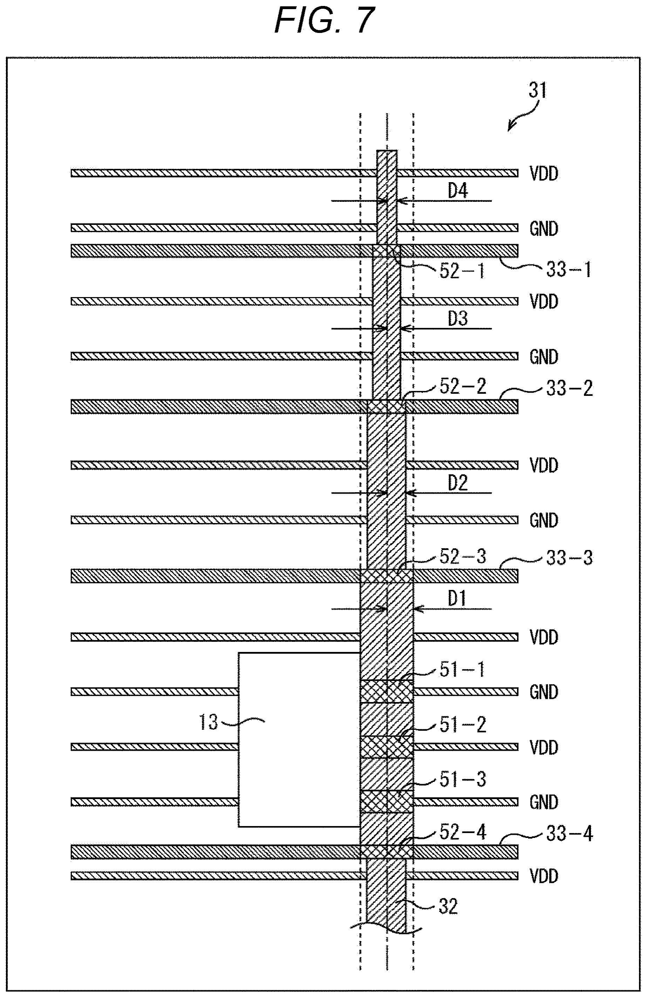

Fig. 7 illustrates a specific wiring shape of the clock wiring 31 described with reference to Fig. 3.

In the clock wiring 31 illustrated in Fig. 7, the driver 13 is arranged at the center of gravity of the plurality of receivers 14 (Fig. 1). Then, the driver 13 is connected to the trunk line 32 having a large wiring width via the through electrodes 51-1 to 51-3. Furthermore, the branch lines 33-1 to 33-4 having a smaller wiring width are connected to the trunk line 32 via through electrodes 52-1 to 52-4, respectively. Moreover, in the clock wiring 31, a plurality of VDD lines and a plurality of GND lines are arranged at regular intervals in parallel with the branch lines 33. Furthermore, the wiring shape of the clock wiring 31 is bilaterally symmetrical with respect to the center line of the trunk line 32.

Then, since the current density decreases as the trunk line 32 approaches a far end, as described above, the wiring shape of the trunk line 32 is set so that the wiring width becomes gradually smaller so that a resistance increases toward a far end side, according to a change in the current density. Furthermore, the trunk line 32 is formed so that the wiring width becomes smaller by, for example, a predetermined constant width every constant distance from the connection portion of the driver 13.

For example, the wiring shape of the trunk line 32 is set so that the wiring width becomes smaller so as to be symmetrical with respect to the center line for every branch portion where the branch lines 33-1 to 33-3 are branched, from the connection portion of the driver 13 toward an upper side (similarly, toward a lower side (not illustrated)). That is, the trunk line 32 is formed so that the wiring width changes from a wiring width D1 to a wiring width D2 (< D1) at a branch portion where the branch line 33-3 is branched, changes from the wiring width D2 to a wiring width D3 (< D2) at a branch portion where the branch line 33-2 is branched, and changes from the wiring width D3 to a wiring width D4 (< D3) at a branch portion where the branch line 33-1 is branched. Note that in the present embodiment, a wiring width D is formed so as to be symmetrical with respect to the center line, and will hereinafter be described as a width on one side with respect to the center line (that is, an actual wiring width is twice D), similar to Fig. 7.

Specifically, a configuration example in which the driver 13 drives the clock wiring 31 of which total capacity including a wiring capacity and a gate capacity is 10 pF, a rate is controlled by Signal EM, a required wiring width on the driver 13 side is 5 µm, a total capacity (wiring capacity and gate capacity) connected to the receiver 14 is 0.1 pF, and a required wiring width on the receiver 14 side is 0.5 µm will be described. In such a configuration example, a drive charge decreases as the trunk line approaches the far end. Therefore, in a case where ten branch lines 33 are branched on one side of the trunk line 32 in a fishbone wiring shape as illustrated in Fig. 7, it is preferable to set the wiring shape so that the wiring width of the trunk line 32 becomes smaller by 0.5 µm for every branch portion. Therefore, a redundant wiring capacity in the clock wiring 31 can be eliminated.

As such, conditions for appropriately eliminating the redundant wiring capacity of the clock wiring 31 vary depending on layout situations, circuit situations or the like such as the wiring capacity or the gate capacity, the required wiring width, the number of branch lines 33, and the like. Therefore, it is necessary to appropriately design the wiring shape so as to narrow the wiring width of the trunk line 32 according to those conditions.

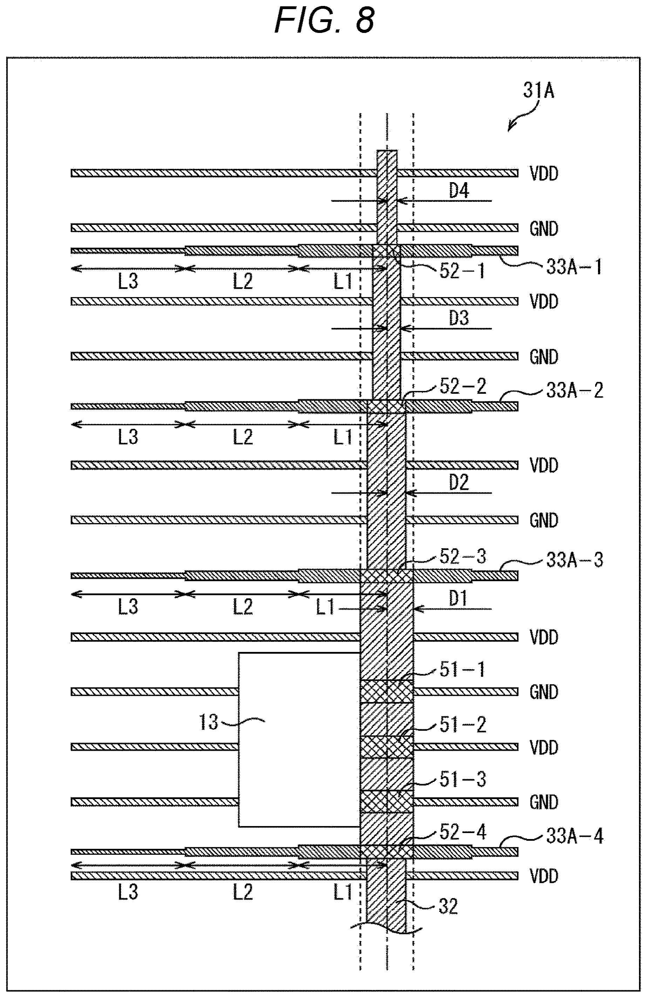

Fig. 8 illustrates a modification of the wiring shape of the clock wiring 31 illustrated in Fig. 7.

In a clock wiring 31A illustrated in Fig. 8, branch lines 33A-1 to 33A-4 branched from the trunk line 32 have wiring shapes set so that wiring widths become smaller according to distances from the trunk line 32, that is, as distances from the driver 13 increase. For example, a plurality of branch lines 33A forming the clock wiring 31A is formed so that the wiring widths become evenly smaller from the center line by a predetermined constant width every constant distance from branch portions from the trunk line 32.

For example, as illustrated in Fig. 8, the branch lines 33A-1 to 33A-4 are formed so that the wiring widths become smaller every constant distance in the order of a length L1 from the center line of the trunk line 32, a length L2 following the length L1, and a length L3 (L1 = L2 = L3) following the length L1.

As such, in the clock wiring 31A, better performance can be obtained by optimizing the wiring widths of the trunk line 32 and the branch lines 33A.

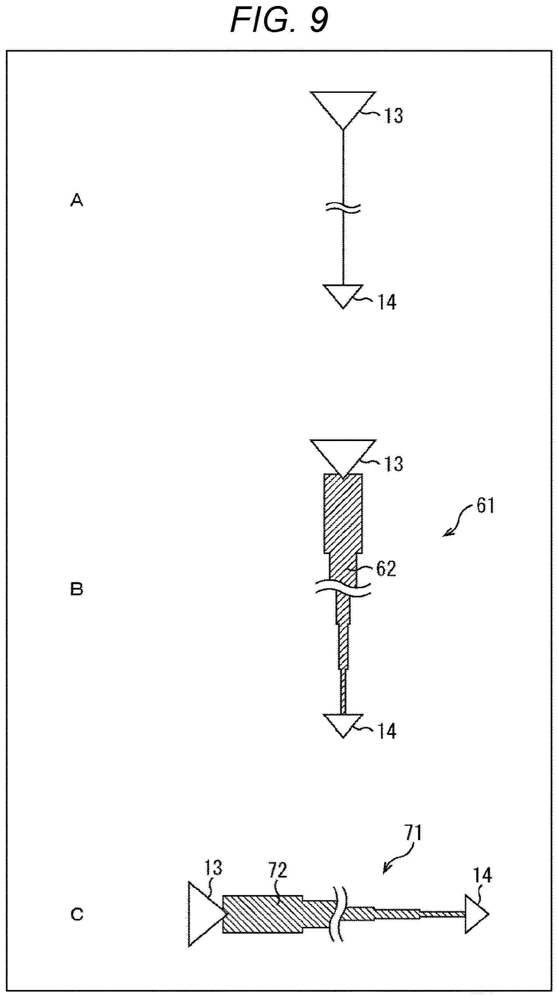

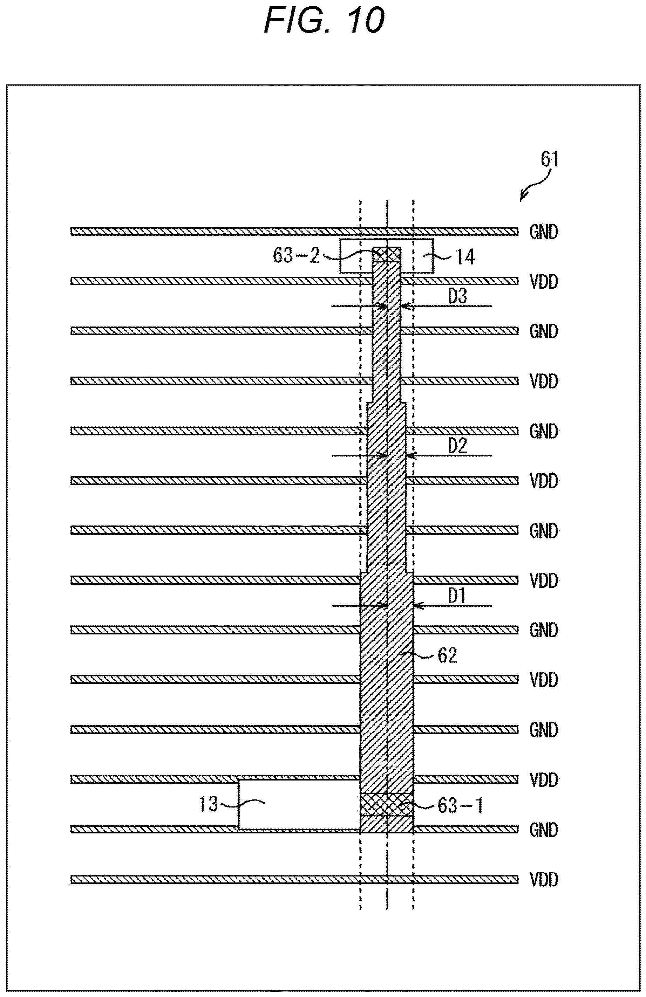

A wiring shape in which the present technology is applied to a long-distance wiring will be described with reference to Figs. 9 and 10.

A of Fig. 9 illustrates a circuit diagram of a long-distance wiring. As illustrated in A of Fig. 9, an output terminal of the driver 13 is connected to an input terminal of the receiver 14 and a distance between the driver 13 and the receiver 14 is greater than or equal to a predetermined distance, in a single wiring without providing a branch between the driver 13 and the receiver 14.

B of Fig. 9 and C of Fig. 9 illustrate layout diagrams illustrating wiring shapes to which the present technology is applied, based on the circuit diagram illustrated in A of Fig. 9. Furthermore, a clock wiring 61 of B of Fig. 9 has a layout in which a long-distance wiring 62 is arranged along the vertical direction of the semiconductor integrated circuit, and a clock wiring 71 of C of Fig. 9 has a layout in which a long-distance wiring 72 is arranged along the horizontal direction of the semiconductor integrated circuit.

As illustrated in B of Fig. 9, in the clock wiring 61, the long-distance wiring 62 has a wiring shape set so that a wiring width becomes smaller according to a distance from a connection portion of the driver 13 to upper and lower sides in the vertical direction, and is connected to the receiver 14. That is, since a current density of a signal transmitted via the long-distance wiring 62 decreases as a distance from the driver 13 increases, the long-distance wiring 62 is formed so that the wiring width becomes smaller according to the decrease in the current density.

Similarly, as illustrated in C of Fig. 9, in the clock wiring 71, the long-distance wiring 72 has a wiring shape set so that a wiring width becomes smaller according to a distance from a connection portion of the driver 13 to the left and right in the horizontal direction, and is connected to the receiver 14. That is, since a current density of a signal transmitted via the long-distance wiring 72 decreases as a distance from the driver 13 increases, the long-distance wiring 72 is formed so that the wiring width becomes smaller according to the decrease in the current density.

The clock wirings 61 and 71 having such wiring shapes are large-scale wirings using the long-distance wirings 62 and 72 having a length of a predetermined distance or more, specifically, about 100 µm to 15 mm, and have wiring shapes set depending on the current densities. As such, better performance can be obtained by optimizing the wiring width in the wiring where a difference occurs in the current density regardless of the number of receivers 14, a distance from the driver 13 to the receiver 14, or the like.

Fig. 10 illustrates a specific wiring shape of the clock wiring 61 illustrated in B of Fig. 9.

As illustrated in Fig. 10, the driver 13 is connected to one end of the long-distance wiring 62 via a through electrode 63-1 and the receiver 14 is connected to the other end of the long-distance wiring 62 via a through electrode 63-2.

Then, in the clock wiring 61, the current density decreases as the long-distance wiring 62 approaches the receiver 14, and the wiring shape of the long-distance wiring 62 is thus set so that the wiring width becomes smaller according to a change in the current density. For example, the wiring shape of the long-distance wiring 62 is set so that the wiring width becomes smaller so as to be symmetrical with respect to the center line from a connection portion of the driver 13 toward an upper side. That is, the wiring shape of the long-distance wiring 62 is set so that the wiring width changes from a wiring width D1 to a wiring width D2 (< D1) and changes from the wiring width D2 to a wiring width D3 (< D2), according to a distance from the driver 13.

Specifically, in a case of the wiring shape in which the wiring width becomes smaller according to the distance away from the connection portion of the driver 13, it is preferable to narrow the wiring width of the long-distance wiring 62 at a pitch of 10 µm to 100 µm and set the wiring shape so that the wiring width is a minimum width at a connection portion of the receiver 14. Alternatively, in a case where a length of the long-distance wiring 62 is about 100 µm to 15 mm, it is possible to make the wiring shape optimal by calculating a wiring width required at the connection portion of the receiver 14, which is a far end, and gradually narrowing the wiring width from the driver 13 side with a value evenly divided so that the wiring width at the connection portion of the receiver 14 is the calculated wiring width.

By applying the wiring shape as described above, a wiring capacity is reduced, such that an amount of current can be reduced, power consumption can be reduced, and electro magnetic interference (EMI) characteristics can be improved.

Furthermore, the wiring capacity can be reduced, such that a load capacity can be reduced, a speed can be improved, and a drive capacity of the driver 13 can be reduced. As a result, power can be improved and an area can be reduced. Accordingly, the reduced area can be used for other wirings, such that a wiring property can be improved.

Moreover, by applying the wiring shape described above, a resistance value on the far end side increases, such that it is possible to reduce occurrence of reflection in a signal. Furthermore, areas of an upper layer wiring and a through electrode are reduced, such that antenna characteristics can also be improved. In particular, for a high-frequency clock in which the reflection of the signal easily occurs, a fine process in which electro migration (EM) is problematic, a large-scale wiring, or the like, better characteristics can be obtained.

### <Second embodiment of wiring shape>

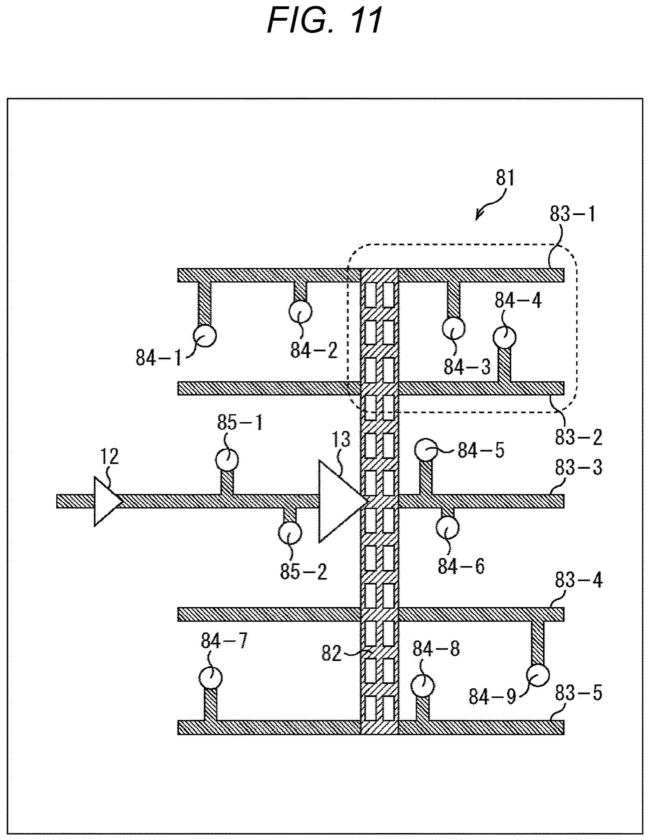

A second embodiment of a wiring shape used in a semiconductor integrated circuit to which the present technology is applied will be described with reference to Figs. 11 to 17.

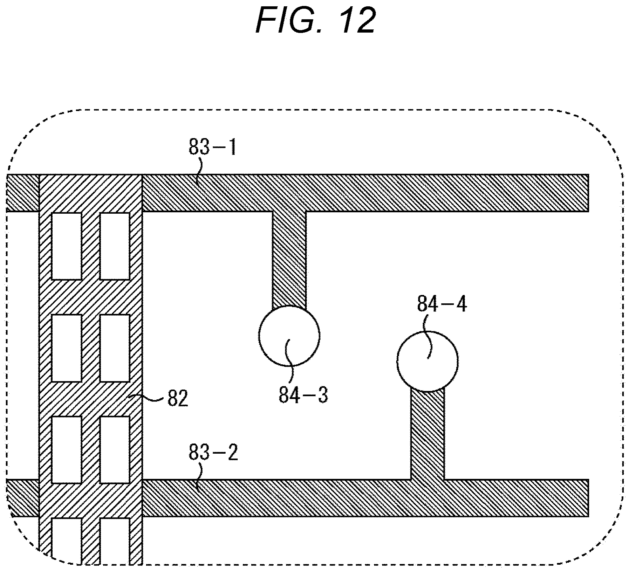

Fig. 11 illustrates a layout diagram illustrating a wiring shape to which the present technology is applied, based on the circuit diagram illustrated in Fig. 1. Furthermore, Fig. 12 enlarges and illustrates an area surrounded by a broken line in Fig. 11.

A clock wiring 81 illustrated in Figs. 11 and 12 has a fishbone wiring shape in which five branch lines 83-1 and 83-5 having a small wiring width are connected to a trunk line 82 having a large wiring width so as to be branched from the trunk line 82, similar to the clock wiring 21 of Fig. 2. Note that the clock wiring 81 of Fig. 11 has a layout in which the trunk line 82 is arranged along a vertical direction of a semiconductor integrated circuit.

Furthermore, in the clock wiring 81, connection terminals 84-1 to 84-9 connected to the receivers 14-1 to 14-9 of Fig. 1 are provided on the branch lines 33-1 to 33-5. Furthermore, connection terminals 85-1 and 85-2 are also provided between a buffer 12 and a driver 13.

Then, in the clock wiring 81, in a case where an output terminal of the driver 13 is connected to the center of the trunk line 82 and a transmitted signal has a high frequency, a wiring shape of the trunk line 82 is set to be a mesh shape in which a plurality of slits is formed according to a frequency of the signal transmitted by the trunk line 82.

Generally, as the frequency of the signal transmitted by the trunk line 82 becomes high, a ratio of a skin resistance component increases due to a direct current (DC) resistance. Therefore, in the clock wiring 81 via which a high-frequency signal is transmitted, the plurality of slits is formed in the trunk line 82 so as to become finer according to the frequency, such that it is possible to reduce the skin resistance component as the mesh shape in which a surface area of the trunk line 82 is increased.

Therefore, in the clock wiring 81, the wiring shape is set to be the mesh shape by forming the plurality of slits, such that a skin resistance can be reduced and attenuation of the signal can be suppressed. As a result, performance of the semiconductor integrated circuit including the clock wiring 81 can be improved.

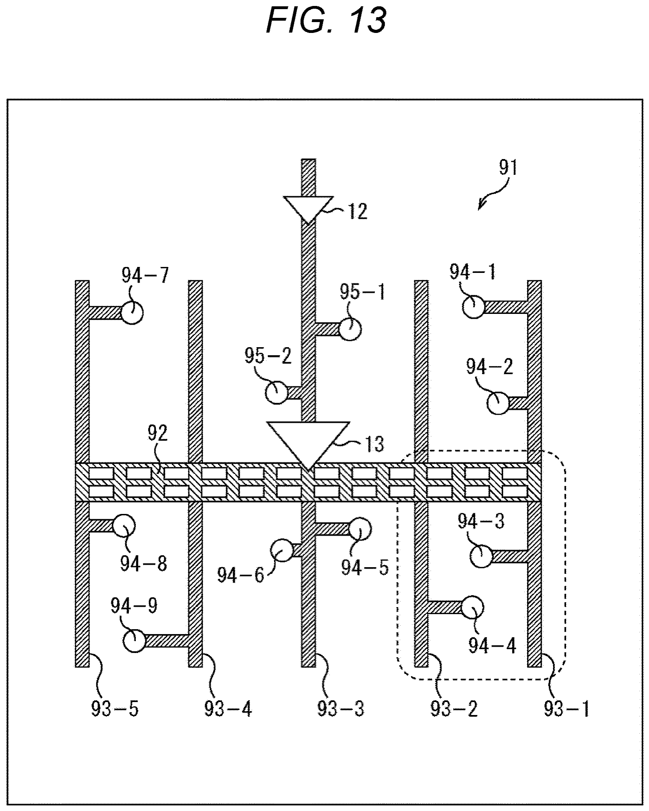

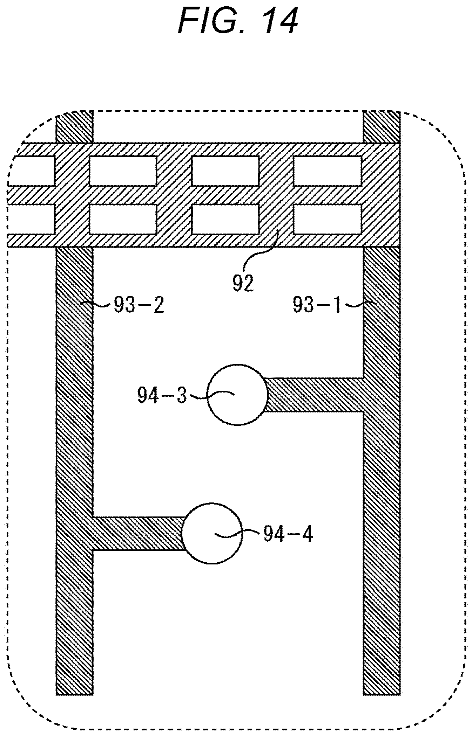

Fig. 13 illustrates a layout diagram illustrating a wiring shape to which the present technology is applied, based on the circuit diagram illustrated in Fig. 1, similar to Fig. 11. Furthermore, Fig. 14 enlarges and illustrates an area surrounded by a broken line in Fig. 13, similar to Fig. 12.

A clock wiring 91 illustrated in Figs. 13 and 14 has a layout in which a trunk line 92 to which the driver 13 is connected is arranged along a horizontal direction of the semiconductor integrated circuit.

Then, as illustrated in Fig. 13, in the clock wiring 91, similar to the clock wiring 81 of Fig. 11, a wiring shape of the trunk line 92 to which the driver 13 is connected is set to be a mesh shape in which a plurality of slits is formed according to a frequency of a signal transmitted by the trunk line 92.

In the clock wiring 91 having such a wiring shape, similar to the clock wiring 81 of Fig. 11, better performance can be obtained by forming the trunk line 92 in an optimum mesh shape according to the frequency of the signal.

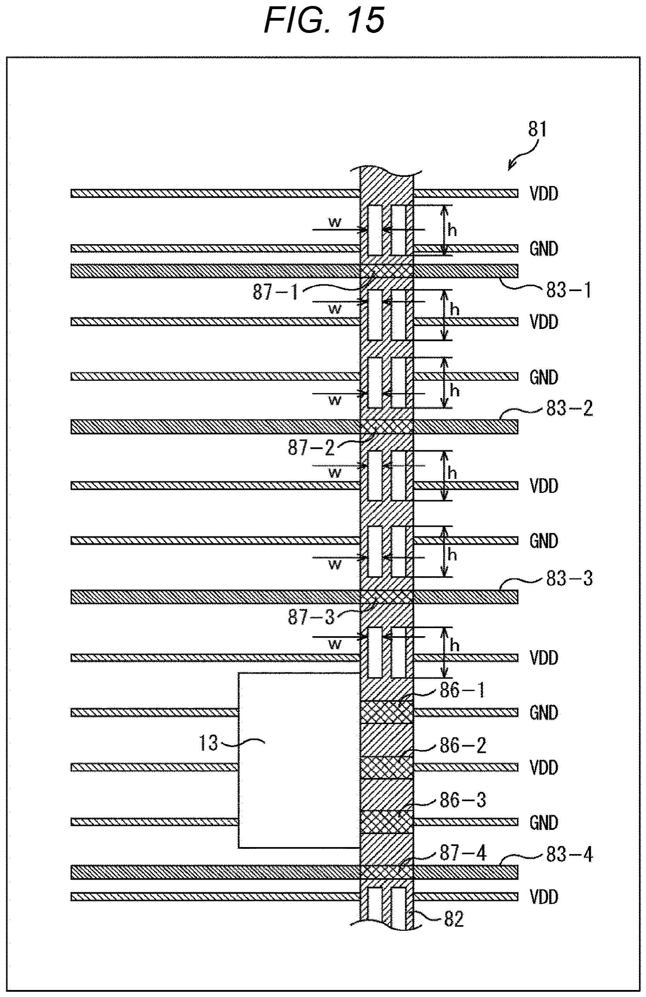

Fig. 15 illustrates a specific wiring shape of the clock wiring 81 described with reference to Fig. 11.

In the clock wiring 81 illustrated in Fig. 15, the driver 13 is connected to the trunk line 82 having a large wiring width via through electrodes 86-1 to 86-3. Furthermore, the branch lines 83-1 to 83-4 having a small wiring width are connected to the trunk line 82 via through electrodes 87-1 to 87-4, respectively. Moreover, in the clock wiring 81, a plurality of VDD lines and a plurality of GND lines are arranged in parallel with the branch lines 33. Furthermore, the wiring shape of the clock wiring 81 is bilaterally symmetrical with respect to the center line of the trunk line 82.

Then, as described above, the slits having a width w and a height h are formed at a plurality of places of the trunk line 82, and the wiring shape of the trunk line 82 is set to be the mesh shape by these slits. For example, the width w and the height h of the slit are formed to be smaller dimensions as the frequency of the signal transmitted by the clock wiring 81 becomes high, such that the trunk line 82 is formed in a finer mesh shape.

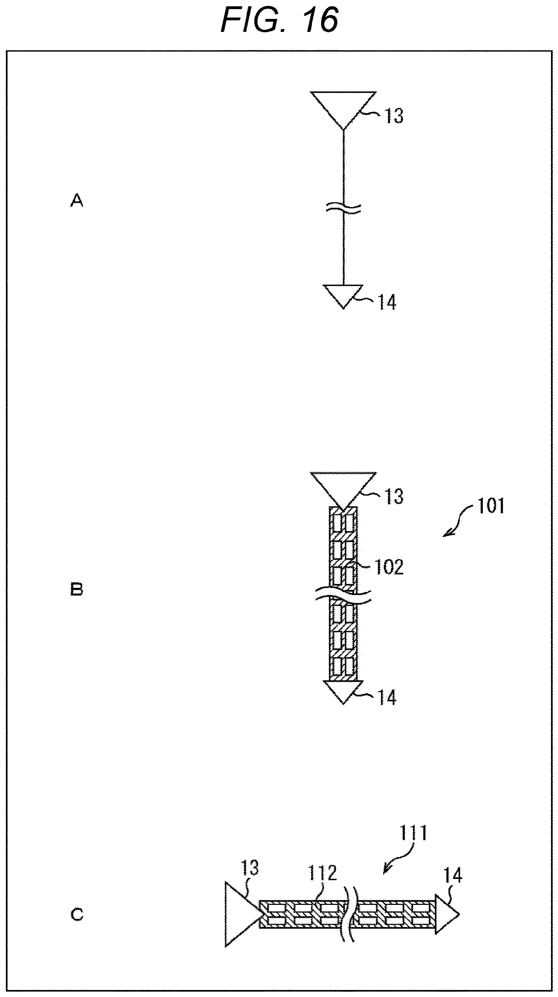

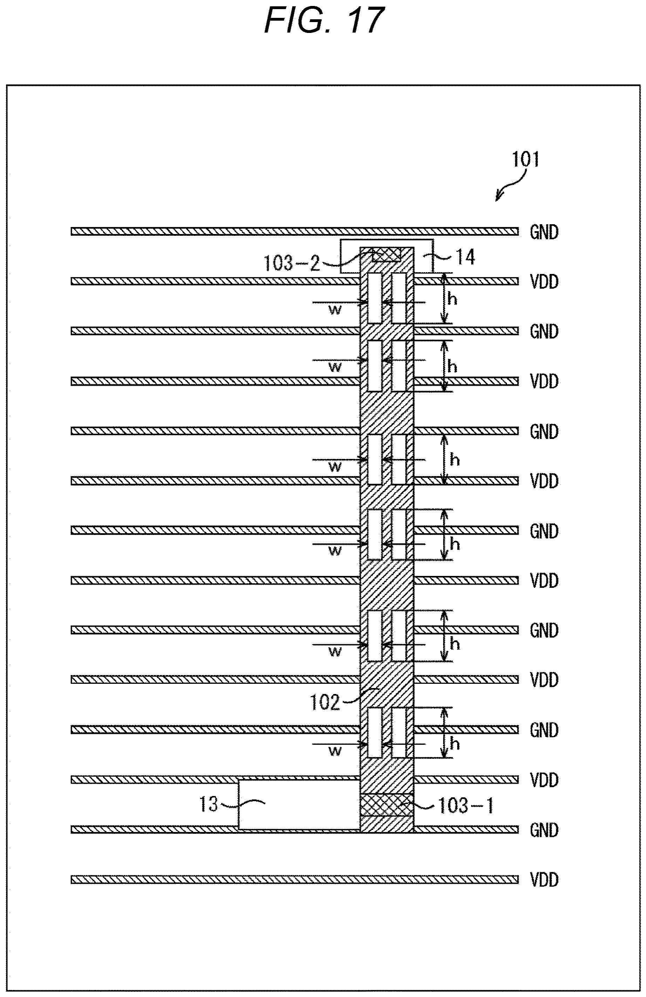

A wiring shape in which the present technology is applied to a long-distance wiring will be described with reference to Figs. 16 and 17.

A of Fig. 16 illustrates a circuit diagram of a long-distance wiring, as illustrated in A of Fig. 16, an output terminal of the driver 13 is connected to an input terminal of the receiver 14 in a single wiring without providing a branch between the driver 13 and the receiver 14.

B of Fig. 16 and C of Fig. 16 illustrate layout diagrams illustrating wiring shapes to which the present technology is applied, based on the circuit diagram illustrated in A of Fig. 16. Furthermore, a clock wiring 101 of B of Fig. 16 has a layout in which a long-distance wiring 102 is arranged along the vertical direction of the semiconductor integrated circuit, and a clock wiring 111 of C of Fig. 16 has a layout in which a long-distance wiring 112 is arranged along the horizontal direction of the semiconductor integrated circuit.

As illustrated in B of Fig. 16, in the clock wiring 101, the long-distance wiring 102 directed toward the vertical direction has a wiring shape set so that a plurality of slits is formed according to a frequency of a signal transmitted through the clock wiring 101, and is connected to the receiver 14. That is, in a case where the signal has a high frequency, the long-distance wiring 102 is formed to have a finer mesh shape so that a surface area increases by forming the slits.

Similarly, as illustrated in C of Fig. 17, in the clock wiring 111, the long-distance wiring 112 directed toward the horizontal direction has a wiring shape set so that a plurality of slits is formed according to a frequency of a signal transmitted through the clock wiring 111, and is connected to the receiver 14. That is, in a case where the signal has a high frequency, the long-distance wiring 112 is formed to have a finer mesh shape so that a surface area increases by forming the slits.

The clock wirings 101 and 111 having such wiring shapes are large-scale wirings using the long-distance wirings 102 and 112 having a length of a predetermined distance or more, specifically, about 100 µm to 15 mm, and have wiring shapes set depending on the frequency of the signal. As such, better performance can be obtained by optimizing the slits according to the frequency of the transmitted signal regardless of the number of receivers 14, a distance from the driver 13 to the receiver 14, or the like.

Fig. 17 illustrates a specific wiring shape of the clock wiring 101 illustrated in B of Fig. 16.

As illustrated in Fig. 17, the driver 13 is connected to one end of the long-distance wiring 102 via a through electrode 103-1 and the receiver 14 is connected to the other end of the long-distance wiring 102 via a through electrode 103-2.

Then, in the clock wiring 101, the slits having a width w and a height h are formed at a plurality of places of the long-distance wiring 102, and the wiring shape of the long-distance wiring 102 is set to be the mesh shape by these slits. Therefore, a surface area of the long-distance wiring 102 can be increased, such that attenuation of the signal due to a skin resistance can be reduced.

For example, in the clock wiring 101, as the frequency of the signal transmitted by the long-distance wiring 102 becomes high, the width w and the height h of the slit are reduced, such that the wiring shape of the long-distance wiring 102 is set to be the finer mesh shape.

By applying the wiring shape as described above, the skin resistance is reduced, such that the attenuation of the signal can be suppressed and a speed can be improved. Furthermore, a wiring capacity can be reduced, and power consumption can be reduced.

### <Wiring shape of power supply wiring>

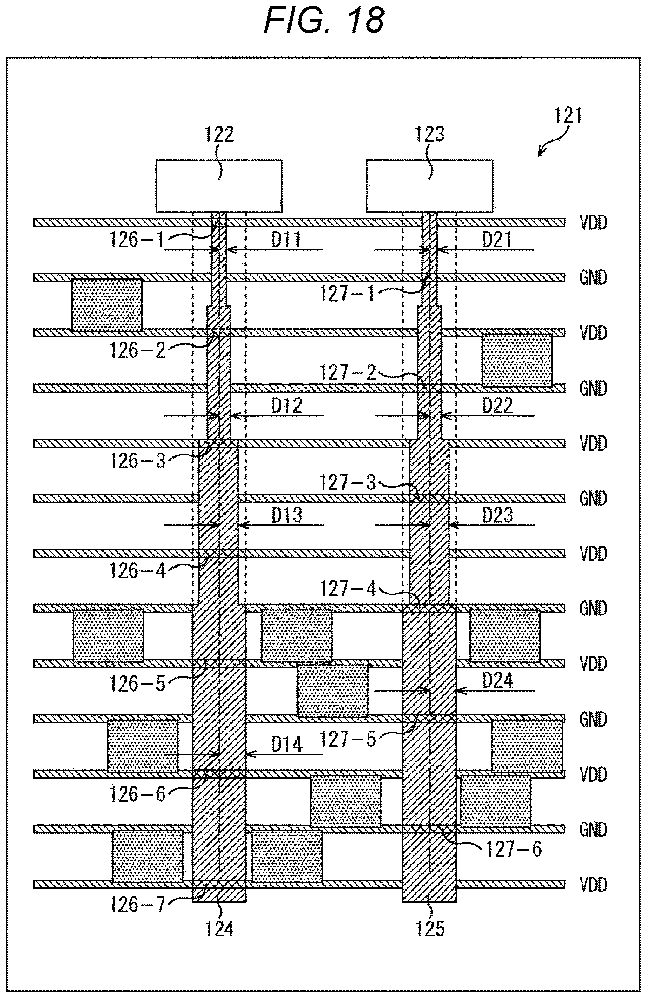

A power supply wiring to which the present technology is applied will be described with reference to Fig. 18.

Fig. 18 illustrates a layout diagram of a power supply wiring.

A power supply wiring 121 illustrated in Fig. 18 includes a current supply source 122 and a GND supply source 123, a VDD trunk line 124 is connected to the current supply source 122, and a GND trunk line 125 is connected to the GND supply source 123.

Furthermore, the VDD trunk line 124 and the GND trunk line 125 having a large wiring width are arranged along the vertical direction of the semiconductor integrated circuit, and a plurality of VDD lines and a plurality of GND lines having a small wiring width are arranged along the horizontal direction of the semiconductor integrated circuit. Then, in the power supply wiring 121, the VDD trunk line 124 is connected to each of seven VDD lines via through electrodes 126-1 to 126-7, and the GND trunk line 125 is connected to each of six GND lines via through electrodes 127-1 to 127-6.

Furthermore, in an example illustrated in Fig. 18, a plurality of power consumption sources (for example, transistors) indicated by dot hatching is connected between VDD lines and GND lines at desired places.

In such a power supply wiring 121, the VDD trunk line 124 has a wiring shape set so that a wiring width becomes larger as a distance from the current supply source 122 increases. That is, the VDD trunk line 124 is formed so that the wiring width changes from a wiring width D11 to a wiring width D12 (> D11), changes from the wiring width D12 to a wiring width D13 (> D12), and changes from the wiring width D13 to a wiring width D14 (> D13), every constant distance from the current supply source 122.

Furthermore, the VDD trunk line 124 is formed to have a larger wiring width for, for example, each of the plurality of power consumption sources each time the power consumption sources are connected. In the example illustrated in Fig. 18, the power consumption sources are arranged so as to be dense at a place away from the current supply source 122, and the wiring shape of the VDD trunk line 124 is set so that the wiring width becomes larger toward the place.

Similarly, in the power supply wiring 121, the GND trunk line 125 has a wiring shape set so that a wiring width becomes larger as a distance from the GND supply source 123 increases. That is, the GND trunk line 125 is formed so that the wiring width changes from a wiring width D21 to a wiring width D22 (> D21), changes from the wiring width D22 to a wiring width D23 (> D22), and changes from the wiring width D23 to a wiring width D24 (> D23), every constant distance from the GND supply source 123.

Furthermore, the GND trunk line 125 is formed to have a larger wiring width for, for example, each of the plurality of power consumption sources each time the power consumption sources are connected. In the example illustrated in Fig. 18, the power consumption sources are arranged so as to be dense at a place away from the GND supply source 123, and the wiring shape of the GND trunk line 125 is set so that the wiring width becomes larger toward the place.

Therefore, the power supply wiring 121 can realize an even voltage drop (IR Drop) along a longitudinal direction of the current supply source 122 and the GND supply source 123, and can improve resistance to an arrangement variation of the plurality of power consumption sources.

By applying the wiring shape as described above, the voltage drop can be made uniform, such that a jitter generated in a signal waveform can be improved or a signal timing can be improved, and better characteristics can resultantly be obtained.

### <Impedance matching>

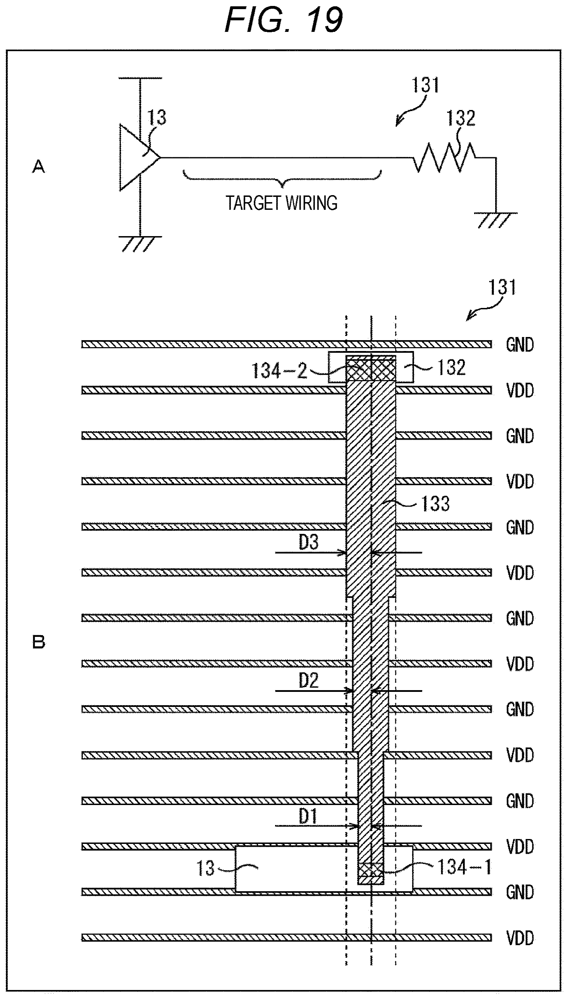

Impedance matching will be described with reference to Fig. 19.

A of Fig. 19 illustrates a circuit diagram of a wiring for performing impedance matching.

As illustrated of A in Fig. 19, in a wiring 131, an output terminal of the driver 13 is grounded via a terminating resistor 132.

As illustrated in B of Fig. 19, the driver 13 is connected to one end of a signal line 133, which is a target for taking an impedance via a through electrode 134-1, and the terminating resistor 132 is connected to the other end of the signal line 133 via a through electrode 134-2. Furthermore, as illustrated in B of Fig. 19, the signal line 133 is arranged along the vertical direction of the semiconductor integrated circuit, and a plurality of VDD lines and a plurality of GND lines are arranged along the horizontal direction of the semiconductor integrated circuit.

Then, the signal line 133 has a wiring shape set so that a wiring width becomes larger from the driver 13 toward the terminating resistor 132 so that the impedance is matched. That is, the signal line 133 is formed so that the wiring width changes from a wiring width D1 to a wiring width D2 (> D1) and changes from the wiring width D2 to a wiring width D3 (> D2), every constant distance from the driver 13.

Therefore, in the wiring 131, impedance matching can be performed by the signal line 133 so that an output impedance of the driver 13 and an input impedance of the terminating resistor 132 become equal to each other.

By applying the wiring shape as described above, electromagnetic radiation can be suppressed and reflection of a signal can be reduced, such that reliability can be improved, and better characteristics can resultantly be obtained.

### <Example in which current concentration occurs>

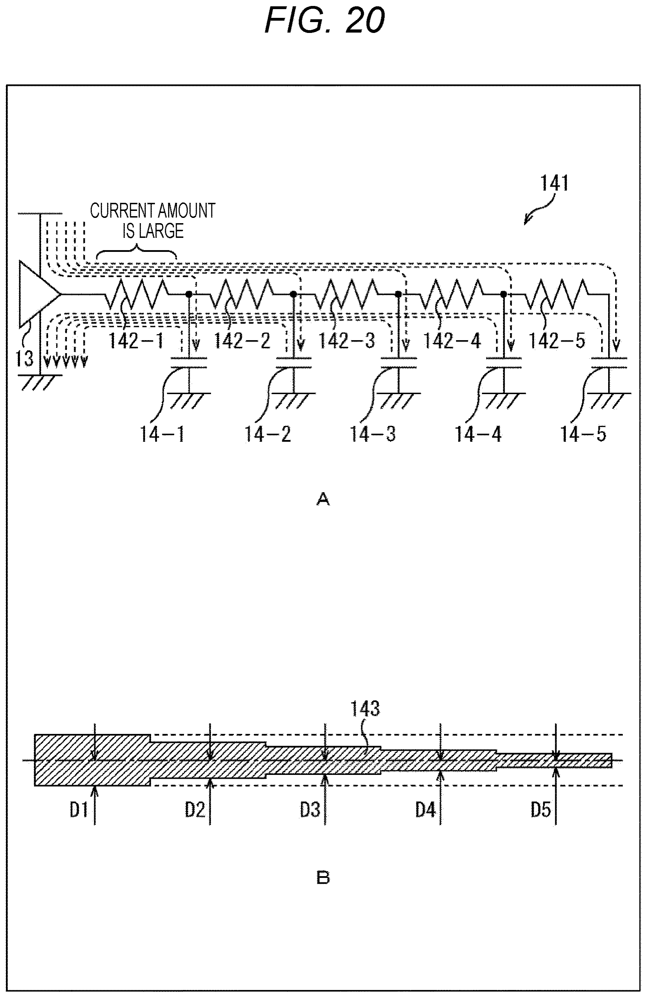

An example in which current concentration occurs will be described with reference to Fig. 20.

In a wiring 141 as illustrated in A of Fig. 20, if current densities on a driver 13 side and receiver 14-1 to 14-5 sides are compared with each other, the current density is higher on the driver 13 side than on the receiver 14-1 to 14-5 sides. Therefore, it is preferable that wiring resistors 142-1 to 142-5 from the driver 13 side to the receiver 14-5 are set to have the largest current density on the driver 13 side.

Therefore, as illustrated in B of Fig. 20, in the wiring 141, a signal line 143 having a wiring shape in which a wiring width becomes large on the driver 13 side having a high current density and becomes small on the receiver 14-5 side having a low current density is adopted. That is, the signal line 143 is formed so that the wiring width changes from a wiring width D1 to a wiring width D2 (< D1), changes from the wiring width D2 to a wiring width D3 (< D2), changes from the wiring width D3 to a wiring width D4 (< D3), and changes from the wiring width D4 to a wiring width D5 (< D5), from the driver 13 for every connection portion where the receiver 14 is connected.

By adopting such a wiring shape, it is possible to reduce a redundant wiring capacity in the wiring 141.

As described above, in the semiconductor integrated circuit to which the wiring shape of each of the embodiments described above is applied, the wiring width of the signal line is formed to become gradually smaller so that the resistance increases toward the far end side, such that reflection of a signal, electromagnetic radiation, or the like, can be reduced. Furthermore, in the semiconductor integrated circuit, the wiring width of the power supply wiring is formed to become gradually larger toward the far end side, such that an amount of voltage drop can be controlled, a more uniform voltage drop can be realized, and resistance to a variation can be improved.

Furthermore, the semiconductor integrated circuit to which the wiring shape of each of the embodiments described above is applied can be applied to a design aiming at a high speed or a design aiming at low power consumption to realize further improvement of performance. For example, the semiconductor integrated circuit can be more effective for a design requiring a high-speed (1 GHz or higher) clock or a large-scale (1 pF or higher) wiring.

Moreover, in the future, as miniaturization of the semiconductor integrated circuit progresses, a wiring becomes thinner and film thinning progresses, such that there is concern about adverse effects such as EM, high resistance or the like, but by applying the wiring shape of each of the embodiments described above, it is possible to suppress those adverse effects. Similarly, due to the progress of the miniaturization, there is a concern about an adverse effect of a variation, and in particular, it is assumed that the uniformity of the voltage drop in the power consumption source (for example, the transistor) as described with reference to FIG. 18 is emphasized, and thus, it is very effective to be able to make the voltage drop uniform as described above.

In particular, for example, in a case where it is necessary to increase the wiring width due to severe EM or the like, in a case where a plurality of wirings should be used, or the like, by applying the present technology, an unnecessary wiring area can be reduced, such that an effect of reducing power consumption can be remarkably obtained. Furthermore, by applying the present technology to, for example, a high-frequency wiring of 1 GHz or higher, a wiring where the receiver 14 side is far away (for example, 3 mm or more), or the like, the wiring width of the wiring on the far end side can be minimized, such that an effect of reflection or noise suppression can be remarkably obtained.

### <Configuration example of electronic apparatus>

The wiring shape of each of the embodiments as described above can be adopted in a semiconductor integrated circuit such as, for example, an imaging element, a signal processing circuit or the like, and can be applied to various electronic apparatuses such as, for example, an imaging system such as a digital still camera, a digital video camera or the like, a mobile phone having an imaging function, or another apparatus having an imaging function.

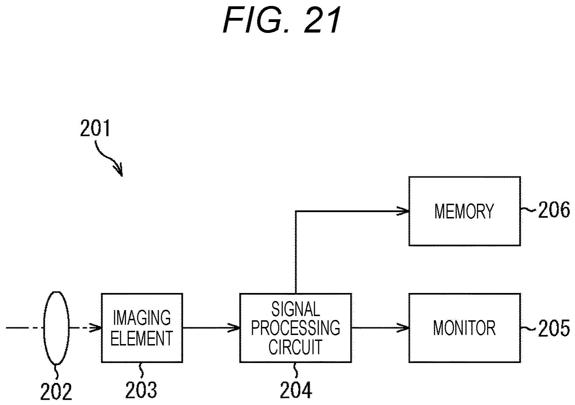

Fig. 21 is a block diagram illustrating a configuration example of an imaging device mounted in an electronic apparatus.

As illustrated in Fig. 21, the imaging device 201 includes an optical system 202, an imaging element 203, a signal processing circuit 204, a monitor 205, and a memory 206, and can capture a still image and a moving image.

The optical system 202 includes one or a plurality of lenses, guides image light (incident light) from a subject to the imaging element 203, and forms an image on a light receiving surface (sensor unit) of the imaging element 203.

A semiconductor integrated circuit that has adopted the wiring shape described above is applied to the imaging element 203. In the imaging element 203, electrons are accumulated for a certain period according to an image formed on the light receiving surface through the optical system 202. Then, a signal corresponding to the electrons accumulated in the imaging element 203 is supplied to the signal processing circuit 204.

A semiconductor integrated circuit that has adopted the wiring shape described above is applied to the signal processing circuit 204, and the signal processing circuit 204 performs various signal processing on a pixel signal output from the imaging element 203. An image (image data) obtained by performing signal processing by the signal processing circuit 204 is supplied to and displayed on the monitor 205 or is supplied to and stored (recorded) in the memory 206.

In the imaging device 201 configured as described above, for example, power consumption can be reduced or reliability can be improved by applying the semiconductor integrated circuit that has adopted the wiring shape described above.

### <Combination example of configuration>

The following configurations are provided for illustration purposes.

A semiconductor integrated circuit including:
a wiring that forms a transmission network through which the same signal is transmitted; and
a driver that supplies the signal to the wiring,
in which the wiring has a wiring shape set according to a distance from the driver or a frequency of the signal.

In some embodiments, the wiring has a wiring shape set so that a wiring width becomes smaller as the distance from the driver increases.

In some embodiments, the wiring width of the wiring becomes small so as to suppress reflection of the signal at an end portion of the wiring in a case where a receiver receiving the signal is a complementary metal oxide semiconductor (CMOS).

In some embodiments, the wiring has a wiring shape set so that the wiring width is in accordance with a current density of the signal.

According to the present invention, the transmission network is formed by a first wiring to which the driver is connected and which has a large wiring width and a plurality of second wirings which is branched from the first wiring and has a small wiring width, and
the first wiring has a wiring shape set so that a wiring width becomes smaller for every branch portion of the second wirings as a distance from a connection portion of the driver increases.

In some embodiments, the first wiring has a central portion to which the driver is connected, and has a wiring width that becomes smaller so that a resistance increases toward a far end side.

In some embodiments, the first wiring is formed so that the wiring width becomes smaller by a predetermined constant width every constant distance from the connection portion of the driver.

In some embodiments, the second wiring is formed so that the wiring width becomes smaller by a predetermined constant width every constant distance from the branch portion from the first wiring.

In some examples provided for illustration purposes, the wiring is a long-distance wiring that singly connects the driver to the receiver and has a predetermined distance or more.

In some examples provided for illustration purposes, the wiring has a wiring shape set to be a mesh shape by forming a plurality of slits in a case where the signal has a high frequency.

In some examples provided for illustration purposes, the wiring is formed in the mesh shape so that the slits become finer as the frequency of the signal increases.

In some examples provided for illustration purposes, the wiring is a long-distance wiring that singly connects the driver to the receiver and has a predetermined distance or more.

In some examples provided for illustration purposes, the wiring is a power supply wiring that supplies power from a current supply source to a plurality of power consumption sources, and has a wiring shape set so that a wiring width becomes larger as a distance from the current supply source increases.

In some examples provided for illustration purposes, the wiring is formed to have a larger wiring width for each of a plurality of the power consumption sources, each time the power consumption sources are connected.

In some examples provided for illustration purposes, the wiring has a wiring shape set so that a wiring width becomes larger from the driver toward a terminating resistor so that an impedance is matched.

In some embodiments, the wiring width of the wiring becomes large by a predetermined constant width every constant distance from the driver.

In some embodiments, an electronic apparatus includes the semiconductor integrated circuit.

Note that the present embodiment is not limited to the embodiment described above, and various modifications can be made without departing from the scope of the present disclosure. Furthermore, effects described in the present specification are merely examples and are not limited, and other effects may be provided.

### REFERENCE SIGNS LIST

11 Clock wiring
12 Buffer
13 Driver
14 Receiver
15 Drive element
31 Clock wiring
32 Trunk line
33 Branch line
34 and 35 Connection terminal
41 Clock wiring
42 Trunk line
43 Branch line
44 and 45 Connection terminal
51 and 52 Through electrode
61 Clock wiring
62 Long-distance wiring
63 Through electrode
71 Clock wiring
72 Long-distance wiring
81 Clock wiring
82 Trunk line
83 Branch line
84 and 85 Connection terminal
86 and 87 Through electrode
91 Clock wiring
92 Trunk line
93 Branch line
94 and 95 Connection terminal
101 Clock wiring
102 Long-distance wiring
103 Through electrode
111 Clock wiring
112 Long-distance wiring
121 Power supply wiring
122 Current supply source
123 GND supply source
124 VDD trunk line
125 GND trunk line
126 and 127 Through electrode
131 Wiring
132 Terminating resistor
133 Signal line
134 Through electrode
141 Wiring
142 Wiring resistor
143 Wiring

## Claims

1. A semiconductor integrated circuit comprising:
a wiring (11; 31; 31A; 41; 71) configured to form a transmission network through which a same signal is transmitted; and
a driver (13) configured to supply the signal to the wiring (11; 31; 31A; 41; 71),
wherein the wiring (11; 31; 31A; 41; 71) has a wiring shape set according to a distance from the driver (13) or a frequency of the signal;
wherein the wiring (11; 31; 31A; 41; 71) is branched from an output terminal of the driver (13) and configured to be connected to an input terminal of a receiver (14; 14-1, 14-2, 14-3, 14-4, 14-5, 14-6, 14-7, 14-8, 14-9);
wherein the transmission network is formed by a first wiring (32; 42) to which the driver (13) is connected and which has a large wiring width and a plurality of second wirings (33-1, 33-2, 33-3, 33-4, 33-5; 33A-1, 33A-2, 33A-3, 33A-4; 43-1, 43-2, 43-3, 43-4, 43-5) which is branched from the first wiring (32; 42) and has a smaller wiring width,
**characterized in that**
the first wiring (32; 42) has a wiring shape set so that a wiring width becomes smaller for every branch portion of the second wirings (33-1, 33-2, 33-3, 33-4, 33-5; 33A-1, 33A-2, 33A-3, 33A-4; 43-1, 43-2, 43-3, 43-4, 43-5) as a distance from a connection portion of the driver (13) increases; and
wherein the wiring shape of the first wiring (11; 31; 31A; 41; 71) is set so that the wiring width corresponds to a decrease in a current density.

2. The semiconductor integrated circuit according to claim 1,
wherein the wiring (11; 31; 31A; 41; 71) has a wiring shape set so that a wiring width becomes smaller as the distance from the driver (13) increases.

3. The semiconductor integrated circuit according to claim 2,
wherein the wiring width of the wiring (11; 31; 31A; 41; 71) becomes smaller so as to suppress reflection of the signal at an end portion of the wiring (11; 31; 31A; 41; 71) in a case where a receiver (14; 14-1, 14-2, 14-3, 14-4, 14-5, 14-6, 14-7, 14-8, 14-9) receiving the signal is a complementary metal oxide semiconductor.

4. The semiconductor integrated circuit according to any one of the previous claims,
wherein the wiring (11; 31; 31A; 41; 71) has a wiring shape set so that the wiring width is in accordance with a current density of the signal.

5. The semiconductor integrated circuit according to any one of the previous claims,
wherein the first wiring (32; 42) has a central portion to which the driver is connected, and has a wiring width that becomes smaller so that a resistance increases toward a far end side.

6. The semiconductor integrated circuit according to any one of the previous claims,
wherein the first wiring (32; 42) is formed so that the wiring width becomes smaller by a predetermined constant width every constant distance from the connection portion of the driver (13).

7. The semiconductor integrated circuit according to any one of the previous claims,
wherein the second wiring (33-1, 33-2, 33-3, 33-4, 33-5; 33A-1, 33A-2, 33A-3, 33A-4; 43-1, 43-2, 43-3, 43-4, 43-5) is formed so that the wiring width becomes smaller by a predetermined constant width every constant distance from the branch portion from the first wiring (32; 42).

8. An electronic apparatus comprising the semiconductor integrated circuit of claim 1.

## Patentansprüche

1. Integrierte Halbleiterschaltung, umfassend:
eine Verdrahtung (11; 31; 31A; 41; 71), die konfiguriert ist, um ein Übertragungsnetzwerk zu bilden, durch das ein gleiches Signal übertragen wird; und
einen Treiber (13), der konfiguriert ist, um das Signal der Verdrahtung (11; 31; 31A; 41; 71) zuzuführen,
wobei die Verdrahtung (11; 31; 31A; 41; 71) eine Verdrahtungsform aufweist, die gemäß einem Abstand vom Treiber (13) oder einer Frequenz des Signals eingestellt ist;
wobei die Verdrahtung (11; 31; 31A; 41; 71) von einem Ausgangsanschluss des Treibers (13) abzweigt und konfiguriert ist, um mit einem Eingangsanschluss eines Empfängers (14; 14-1, 14-2, 14-3, 14-4, 14-5, 14-6, 14-7, 14-8, 14-9) verbunden zu werden;
wobei das Übertragungsnetzwerk durch eine erste Verdrahtung (32; 42), mit der der Treiber (13) verbunden ist und die eine große Verdrahtungsbreite aufweist, und eine Vielzahl von zweiten Verdrahtungen (33-1, 33-2, 33-3, 33-4, 33-5; 33A-1, 33A-2, 33A-3, 33A-4; 43-1, 43-2, 43-3, 43-4, 43-5), die von der ersten Verdrahtung (32; 42) abzweigen und eine geringere Verdrahtungsbreite aufweisen, gebildet wird, **dadurch gekennzeichnet, dass**
die erste Verdrahtung (32; 42) eine Verdrahtungsform aufweist, die so eingestellt ist, dass eine Verdrahtungsbreite für jeden Verzweigungsabschnitt der zweiten Verdrahtungen (33-1, 33-2, 33-3, 33-4, 33-5; 33A-1, 33A-2, 33A-3, 33A-4; 43-1, 43-2, 43-3, 43-4, 43-5) kleiner wird, wenn ein Abstand von einem Verbindungsabschnitt des Treibers (13) zunimmt; und
wobei die Verdrahtungsform der ersten Verdrahtung (11; 31; 31A; 41; 71) so eingestellt ist, dass die Verdrahtungsbreite einer Abnahme in einer Stromdichte entspricht.

2. Integrierte Halbleiterschaltung nach Anspruch 1,
wobei die Verdrahtung (11; 31; 31A; 41; 71) eine Verdrahtungsform aufweist, die so eingestellt ist, dass eine Verdrahtungsbreite kleiner wird, wenn der Abstand vom Treiber (13) zunimmt.

3. Integrierte Halbleiterschaltung nach Anspruch 2,
wobei die Verdrahtungsbreite der Verdrahtung (11; 31; 31A; 41; 71) kleiner wird, um eine Reflexion des Signals an einem Endabschnitt der Verdrahtung (11; 31; 31A; 41; 71) in dem Fall zu unterdrücken, in dem ein Empfänger (14; 14-1, 14-2, 14-3, 14-4, 14-5, 14-6, 14-7, 14-8, 14-9), der das Signal empfängt, ein komplementärer Metall-Oxid-Halbleiter ist.

4. Integrierte Halbleiterschaltung nach einem der vorstehenden Ansprüche,
wobei die Verdrahtung (11; 31; 31A; 41; 71) eine Verdrahtungsform aufweist, die so eingestellt ist, dass die Verdrahtungsbreite in Übereinstimmung mit einer Stromdichte des Signals ist.

5. Integrierte Halbleiterschaltung nach einem der vorstehenden Ansprüche,
wobei die erste Verdrahtung (32; 42) einen zentralen Abschnitt aufweist, mit dem der Treiber verbunden ist, und eine Verdrahtungsbreite aufweist, die kleiner wird, so dass ein Widerstand in Richtung einer entfernten Endseite zunimmt.

6. Integrierte Halbleiterschaltung nach einem der vorstehenden Ansprüche,
wobei die erste Verdrahtung (32; 42) so ausgebildet ist, dass die Verdrahtungsbreite mit jedem konstanten Abstand vom Verbindungsabschnitt des Treibers (13) um eine vorbestimmte konstante Breite kleiner wird.

7. Integrierte Halbleiterschaltung nach einem der vorstehenden Ansprüche,
wobei die zweite Verdrahtung (33-1, 33-2, 33-3, 33-4, 33-5; 33A-1, 33A-2, 33A-3, 33A-4; 43-1, 43-2, 43-3, 43-4, 43-5) so ausgebildet ist, dass die Verdrahtungsbreite mit jedem konstanten Abstand vom Verzweigungsabschnitt von der ersten Verdrahtung (32; 42) um eine vorbestimmte konstante Breite kleiner wird.

8. Elektronisches Gerät, das die integrierte Halbleiterschaltung nach Anspruch 1 umfasst.

## Revendications

1. Circuit intégré à semiconducteurs comprenant :
un câblage (11 ; 31 ; 31A ; 41 ; 71) configuré pour former un réseau de transmission à travers lequel un même signal est transmis ; et
un circuit d'attaque (13) configuré pour fournir le signal au câblage (11 ; 31 ; 31A ; 41 ; 71),
dans lequel le câblage (11 ; 31 ; 31A ; 41 ; 71) a une forme de câblage définie en fonction d'une distance par rapport au circuit d'attaque (13) ou d'une fréquence du signal ;
dans lequel le câblage (11 ; 31 ; 31A ; 41 ; 71) est dérivé d'une borne de sortie du circuit d'attaque (13) et configuré pour être connecté à une borne d'entrée d'un récepteur (14 ; 14-1, 14-2, 14-3, 14-4, 14-5, 14- 6, 14-7, 14-8, 14-9) ;
dans lequel le réseau de transmission est formé par un premier câblage (32 ; 42) auquel le circuit d'attaque (13) est connecté et qui présente une grande largeur de câblage et une pluralité de seconds câblages (33-1, 33-2, 33-3, 33-4, 33-5 ; 33A-1, 33A-2, 33A-3, 33A-4 ; 43-1, 43-2, 43-3, 43-4, 43-5) qui sont dérivés du premier câblage (32 ; 42) et a une largeur de câblage plus petite, **caractérisé en ce que**
le premier câblage (32 ; 42) a une forme de câblage définie de sorte qu'une largeur de câblage se réduit pour chaque partie de dérivation des seconds câblages (33-1, 33-2, 33-3, 33-4, 33-5 ; 33A-1, 33A-2, 33A-3, 33A-4 ; 43-1, 43-2, 43-3, 43-4, 43-5) à mesure qu'une distance par rapport à une partie de connexion du circuit d'attaque (13) augmente ; et
dans lequel la forme de câblage du premier câblage (11 ; 31 ; 31A ; 41 ; 71) est définie de sorte que la largeur de câblage corresponde à une diminution d'une densité de courant.

2. Circuit intégré à semiconducteurs selon la revendication 1,
dans lequel le câblage (11 ; 31 ; 31A ; 41 ; 71) a une forme de câblage définie de sorte qu'une largeur de câblage se réduit à mesure que la distance par rapport au circuit d'attaque (13) augmente.

3. Circuit intégré à semiconducteurs selon la revendication 2,
dans lequel la largeur de câblage du câblage (11 ; 31 ; 31A ; 41 ; 71) se réduit afin de supprimer une réflexion du signal au niveau d'une partie d'extrémité du câblage (11 ; 31 ; 31A ; 41 ; 71) dans le cas où un récepteur (14 ; 14-1, 14-2, 14-3, 14-4, 14-5, 14-6, 14-7, 14-8, 14-9) recevant le signal est un semi-conducteur à oxyde métallique complémentaire.

4. Circuit intégré à semiconducteurs selon l'une quelconque des revendications précédentes,
dans lequel le câblage (11 ; 31 ; 31A ; 41 ; 71) a une forme de câblage définie de sorte que la largeur de câblage est en conformité avec une densité de courant du signal.

5. Circuit intégré à semiconducteurs selon l'une quelconque des revendications précédentes,
dans lequel le premier câblage (32 ; 42) a une partie centrale à laquelle le circuit d'attaque est connecté, et a une largeur de câblage qui se réduit de sorte qu'une résistance augmente vers un côté opposé.

6. Circuit intégré à semiconducteurs selon l'une quelconque des revendications précédentes,
dans lequel le premier câblage (32 ; 42) est formée de sorte que la largeur de câblage se réduit d'une largeur constante prédéterminée à chaque distance constante par rapport à la partie de connexion du circuit d'attaque (13).

7. Circuit intégré à semiconducteurs selon l'une quelconque des revendications précédentes,
dans lequel le second câblage (33-1, 33-2, 33-3, 33-4, 33-5 ; 33A-1, 33A-2, 33A-3, 33A-4 ; 43-1, 43-2, 43-3, 43-4, 43-5) est formée de sorte que la largeur de câblage se réduit d'une largeur constante prédéterminée à chaque distance constante par rapport à la partie de dérivation du premier câblage (32 ; 42).

8. Appareil électronique comprenant le circuit intégré à semiconducteurs selon la revendication 1.
